(19) Europäisches Patentamt

European Patent Office

Office européen des brevets

(11) **EP 1 483 830 B1**

(12) **EUROPEAN PATENT SPECIFICATION**

(45) Date of publication and mention
of the grant of the patent:
**17.08.2005 Bulletin 2005/33**

(51) Int Cl.⁷: **H03F 1/00**

(86) International application number:
**PCT/EP2003/001873**

(21) Application number: **03708129.6**

(22) Date of filing: **24.02.2003**

(87) International publication number:
**WO 2003/075455 (12.09.2003 Gazette 2003/37)**

(54) **AMPLIFIER CIRCUITS AND THEIR USE IN RADIO FREQUENCY TRANSMITTERS**

VERSTÄRKERSCHALTUNGEN UND IHRE VERWENDUNG IN HOCHFREQUENZSENDERN

CIRCUITS D'AMPLIFICATION ET LEUR UTILISATION DANS DES EMETTEURS A FREQUENCE RADIOELECTRIQUE

(84) Designated Contracting States:
**AT BE BG CH CY CZ DE DK EE ES FI FR GB GR HU IE IT LI LU MC NL PT SE SI SK TR**

(30) Priority: **02.03.2002 GB 0204951**

(43) Date of publication of application:
**08.12.2004 Bulletin 2004/50**

(73) Proprietor: **MOTOROLA, INC.**
**Schaumburg, IL 60196 (US)**

(72) Inventor: **PETERSEN, Leif Geert**
**DK-4000 Roskilde (DK)**

(74) Representative: **McCormack, Derek James et al**
**Optimus,**
**Grove House,**
**Lutyens Close,**
**Chineham Court**
**Basingstoke, Hampshire RG24 8AG (GB)**

(56) References cited:
**US-A- 3 900 823      US-A- 5 194 823**
**US-A- 5 710 521**

**Description**

**FIELD OF THE INVENTION**

The present invention relates to amplifier circuits and their use in RF (radio frequency) circuits such as transmitters, especially RF communications transmitters. In particular, it relates it relates to RF power amplifier circuits for use in such RF transmitter or transceiver units.

**BACKGROUND OF THE INVENTION**

Many RF generators such as those used in RF transmitters include power amplifier circuits. Such circuits may for example be employed in a communications transmitter to amplify a modulated RF carrier signal for external transmission by an associated radiating device such as an RF antenna. Such circuits are often required to have a substantial linearity of response providing an output which is a linear function of the input. US-A-3 900 823 discloses a power amplifying and signal processing system for modulated carrier signals separately processes the amplitude component of the system input signal and the component of frequency or phase or both frequency and phase, and later recombines the separately processed components to provide an output signal. The amplitude and phase transfer functions of the system can be accurately controlled. The input signal is fed to a power amplifier whose output provides the output for the system. The input and output signals of the system are fed by separate paths to a comparator which compares those signals and emits an error signal to a controller. The controller regulates the amplitude and phase, or both, of the power amplifier's output to null the error signal. One or both of the paths to the comparator may have in it a non-linear function generator which acts upon the signal fed by that path to the comparator. Circuits operating in a class A and to a lesser extent in a class AB configuration are widely employed to provide linearity. However, such circuits are inefficient and consequently waste relatively large amounts of input power, especially in high power output applications. Amplifier circuits operating in a class C configuration may alternatively be used as power amplifiers. The class C configuration provides an output signal which is approximately in the form of a square waveform produced from a sinusoidal RF input. Such amplifier circuits are of better efficiency than class A and AB circuits but unfortunately are highly non-linear. Class C amplifier circuits are not therefore used commercially in modern communications applications requiring complex linear modulation forms.

**SUMMARY OF THE PRESENT INVENTION**

According to the present invention in a first aspect there is provided an RF amplifier circuit comprising an RF amplifying device having a first input terminal, a second input terminal and an output terminal, means for applying to the first input terminal an input RF signal I to be amplified, means for generating and applying to the second input terminal a threshold signal T, and the amplifying device being operable to produce at the output terminal an output signal O which has a high finite value providing a Boolean '1' value when the instantaneous value of the amplitude of I is greater than T and a low finite value providing a Boolean '0' value when the instantaneous value of the amplitude of I is less than T, wherein the threshold signal T is dynamically varied in a manner adapted to linearise the relationship in at least part of its range between the amplitude of the output signal O and the amplitude of the input signal I.

Preferably, the amplifying device has a bandwidth of at least five times, preferably at least ten times, greater than the mean operating frequency of the signal which it is operable to amplify.

The threshold signal T may be a variable signal which may be combined with the input signal I at the amplifying device as appropriate to give in combination a linear response as illustrated in more detail later. Alternatively, the threshold signal T may be applied as a variable bias signal to the amplifying device.

The threshold signal T may in operation be dynamically varied as a function of the input signal I, e.g. by sampling the input signal I prior to application to the amplifying device. The means for applying the threshold signal T may in this case comprise a feed forward loop which includes as the means for generating the threshold signal T means for generating a signal derived at least in part from the sampled input signal I.

Alternatively, or in addition, the threshold signal T may in operation be dynamically varied as a function of the output signal O, e.g. by sampling the output signal O produced by the amplifying device, optionally after further processing, e.g. filtering. The means for applying the threshold signal T may in this case comprise a feedback loop which includes as the means for generating the threshold signal T means for generating a signal derived at least in part from the sampled output signal O.

Where the threshold signal T is derived from the input signal I and/or the output signal O it may be provided by sampling the relevant signal and deriving as the threshold signal T or a component thereof a signal which is related to the envelope of the monitored signal. For example, the threshold signal T may be derived from a profile of the peak amplitude or of the root mean square amplitude of the varying monitored signal.

In a further alternative embodiment of the invention, the threshold signal T may be generated in an arrangement operable as follows. Variations in amplitude of the input signal I may result from the application of a modulation signal applied in a modulator to an RF carrier signal to form the input signal I. The modulation signal may be generated in the modulator in a known manner by converting input information to be communicated, e.g. digital information produced as an output from a digital signal processor, into the required modulations. The modulation signal may for example comprise digital phase shift modulations of the carrier signal. The phase shift modulations may be applied for example in a known DQPSK (differential quadrature phase shift keying) procedure. The threshold signal T may be a signal derived from the modulation information or the information, e.g. digital (including bidigital) information, to be converted into the modulation signal. The threshold signal T may therefore be derived from an output of a digital signal processor which also produces an output for application to a modulator.

The threshold signal T may have an amplitude profile calculated to correspond to the amplitude profile of the input signal I by an appropriate mathematical operation applied to the modulation signal or of the information employed to produce the modulation signal, e.g. from a digital signal processor. The amplitude profile of the input signal I as a function of the applied modulation signal or information, e.g. digital information, employed to produce it, can be calculated since the amplitude profile resulting from a given modulation signal is in general a known function. Alternatively, or in addition, training measurements, e.g. using a neural network function, can be made of the input amplitude as a function of the applied modulation information or digital information converted into modulation information.

In a transceiver arrangement, the modulated signal generated in the manner described above may initially be a baseband frequency signal which is converted to RF by an upconverter to produce the input signal I. The calculated amplitude function in this case resulting from a given modulation signal will take into account the upconversion step.

The application of a mathematical operation may be carried out by a device referred to herein as an operator. As is known in the art of control design, the mathematical operation or function applied by an operator to produce an output signal from a given input signal applied to the operator is known as a transfer function. In the above embodiments of the invention, the operator used in each case is selected to apply a particular suitable transfer function to a particular input signal I to a produce a particular threshold signal T, e.g. as illustrated further later.

Devices which may be used to provide such an operator are known per se. In general, such a device may include a signal processor, e.g. digital signal processor, which carries out the transfer function. The operator may also include (i) a signal peak monitor which measures the value of the peak of a signal being sampled and produces a peak envelope signal, (ii) an A to D (analogue to digital) converter which digitises the peak envelope signal for application to the signal processor and a D to A (digital to analogue) converter which converts the digitally transformed signal produced by the signal processor back into a waveform suitable for use as the threshold signal T. The operator may also include or be used in conjunction with an amplifier or a plurality of amplifiers to amplify the signal being processed to produce the variable threshold signal T.

The operator could alternatively be an analogue device giving the appropriate transfer function or an approximation of it.

In the embodiment of the invention where the input to the operator comprises a signal produced by a signal processor and applied to the modulator, the signal processor function of the operator may be provided by the same signal processor.

In any of the above embodiments, where a transfer function is applied by an operator to a monitored signal to produce the threshold signal T, the transfer function may be applied by use of a look up table held in a memory which stores corresponding values of the signal before and after application of the transfer function. The stored corresponding values for the look up table may be calculated from known theory and/or obtained by measurement, e.g. in a training mode. The memory may form part of, or be associated with, the signal processor employed to produce output information applied to the modulator.

Digital signal processors (DSP) which may be preprogrammed to carry out pre-determined mathematical operations as transfer functions on variable input signals are known per se. Examples of such mathematical operations for use in the context of the present invention are described later.

The operator could alternatively be an analogue device giving the appropriate transfer function or an approximation of it.

The mathematical operation applied by the transfer function operator is one which provides a variable threshold signal T value which when combined or compared with the input RF signal amplitude value a at the RF amplifier causes the RF amplifier to produce an output signal O having an amplitude which, when plotted as a function of the amplitude value a of the input RF signal I, is substantially linear or approximates to linear in at least part of the plot. Preferably, the plot is linear over at least 80%, desirably at least 90% of its range. This is in contrast to conventional class C amplifier configurations which give a highly non-linear plot when operated in a conventional manner.

The amplifying device employed in the circuit according to the first aspect of the invention may comprise an amplifying device arranged in a class C configuration modified so that the input signal I and the threshold signal T are applied together via separate input terminals to be combined at a single electrode of the amplifying device. The amplifying device may comprise a solid state amplifying device such a transistor which may be in bipolar form or in field effect (JFET or MOSFET) form. For example, where a MOSFET (metal oxide semiconductor field effect transistor) is employed, the input signal I and the threshold signal T may be combined at the gate electrode of the transistor. The output signal O may be extracted from the drain electrode. Where the transistor is in the form of a bipolar junction transistor the input signal I and the threshold signal T may combined at the base of the transistor and the output signal O may be extracted from the collector of the transistor. Bias voltages in each case may be applied as in a usual class C configuration. As mentioned earlier, in one embodiment, the bias voltage e.g. to the emitter in a junction transistor in a class C configuration, may be varied in accordance with the variation in threshold T.

The amplifier circuit according to the first aspect may include two or more amplifying devices. Such devices may be mutually connected in a parallel or a series configuration in a known manner to give a greater output for a given input.

The present invention provides an amplifier circuit which may have a basic configuration similar to that of an RF class C amplifier but which surprisingly and beneficially can provide an amplified output which is a linear function of its input over a substantial part of the output range yet still retain the high efficiency of a class C amplifier. Comparable linearity is only normally obtained with a class A or AB amplifier and the improved linearity provides for amplification of an RF signal a surprisingly good combination of linearity of response and high efficiency. The high operational efficiency leads beneficially to considerably reduced power consumption compared with a class A or AB configuration.

The amplifier circuit according to the present invention may find use in RF circuits for a wide number of applications particularly digital applications. Such applications include transmitters for RF communications, RF smartcards, RF near field excitation devices, radio and television broadcasting, radar and many others. In this specification, 'RF' is generally understood to mean frequencies of greater than 10KHz, e.g. up to 500GHz. In many cases the RF energy produced in the application will have a frequency of from 100KHz to 100GHz.

According to the present invention in a second aspect there is provided a RF communications transmitter which includes an amplifier circuit according to the first aspect.

Where the invention is employed in RF communications transmitters, such transmitters may be incorporated in communications apparatus. For example, the apparatus may comprise a mobile or fixed radio transceiver. Mobile radio transceivers are also referred to herein as mobile stations (MSs). The term 'mobile station (MS)' is intended to include within its meaning apparatus such as mobile and portable telephones and mobile and portable radios, data communication terminals and the like which operate by radio communication. Systems which provide communications to or from MSs by fixed or base transceivers known in the art as 'base transceiver stations' or 'BTSs' may be arranged to give communications coverage in a network of regions known as cells and are referred to herein as cellular radio communications systems.

Thus, the invention may find partcular use in a MS or in a BTS of a mobile or cellular communications system. The operational power levels are much greater in a BTS than in a MS and the benefits of the invention are therefore potentially greater in a BTS. For example, in a BTS power amplification stage in which the invention may be employed, the RF signal may be amplified from a power level of typically 1W to one of typically 50W (e.g. from 25W to 75W). The following potential benefits are available in a BTS or a plurality of BTSs used together in a network control installation often referred to as a SwMI (switching an management infrastructure) installation. Higher efficiency which may be obtained in a linear response circuit compared with the prior art provides reduced power consumption which in turn allows smaller operational units to be built. Compared with currently available units, such smaller units can be built more cheaply using less components and operated more reliably at lower operating temperatures with less need for associated cooling and air conditioning arrangements. Floor space occupied at a BTS site and the cost of its rental may also be beneficially reduced.

The MSs and BTSs in which the invention may find use in a mobile or cellular communications system may be units designed to operate according to the TETRA (Terrestrial Trunked Radio) standards. This is a set of operational standards for modern trunked RF communications systems specified by the ETSI (European Telecommunications Standards Institute). In those standards, the communications protocol involves digital information (e.g. voice, data or video information) being contained in phase components of a RF signal modulated using the DQPSK (differential quadrature phase shift keying) system referred to earlier. Signals sent to a BTS from a MS (uplink) and from a BTS to a MS (downlink) are at different frequencies (FDD or frequency division duplex). Operating frequencies for TETRA systems are narrowband frequency channels which are in several specified frequency ranges including the following: (i) 380MHz-390MHz uplink/390MHz-400MHz downlink; (ii) 410MHz-420MHz uplink/420MHz-430MHz downlink. Each channel used has a bandwidth of 25kHz and can carry 36kbit/sec.

The TETRA modulation protocol is such that the signal amplitude between consecutive digits of information never falls below a minimum level, e.g. approximately 15% of the maximum amplitude, and this is particularly suitable for use of the amplifier circuit according to the invention to amplify such signals. This is because the response of the amplifier circuit can be designed so that amplitudes of input signals to be processed are in a linear response region of the circuit well above any non-linear response region which may apply at very small amplitudes.

If required however, additional linearisers, as known in the art, e.g. for use in conjunction with conventional non-linear class C amplifiers to compensate for non-linarity of the circuit operation, may be employed in conjunction with the amplifier circuit of the present invention to deal with any non-linear response which does occur in part of the response plot in use of the amplifier circuit of the present invention. The output of the amplifier circuit of the present invention may for example provide the input to a Cartesian loop amplifier circuit.

For use in a transceiver (e.g. BTS or MS) to be used in a TETRA communications system, the power amplifier incorporating one or more amplifier circuits according to the invention preferably provides a linear response in an output signal strength range of at least 70dB, preferably at least 80dB.

Known automatic gain control (AGC) amplifying circuits employ threshold signals. However, the amplifier circuit according to the invention is fundamentally different from such circuits. In an AGC circuit, the object is to adjust the gain so that the output level is the same for different input signal strength levels. In contrast, the circuit of the invention is intended to adjust the threshold so that the gain is the same (or remains similar) for varying input levels of a given signal.

Embodiments of the present invention will now be described by way of example with reference to the accompanying drawings, in which:

## BRIEF DESCRIPTION OF THE ACCOMPANYING DRAWINGS

Figure 1 is a schematic representation of a RF threshold power amplifier for use in embodiments of the present invention.

Figure 2 is a graph of input and output amplitude plotted against time for the RF threshold power amplifier shown in Figure 1.

Figure 3 is a graph of amplifier response, namely output amplitude plotted against input amplitude, for different threshold functions used in the RF threshold power amplifier shown in Figure 1.

Figures 4 to 8 are a schematic block circuit diagrams of alternative RF transceivers each including an amplifier circuit embodying the invention employing a RF threshold power amplifier of the kind shown in Figure 1.

Figure 9 is a graph of normalised output as a function of normalised input for a class C power amplifier and also shows the threshold signal T required to provide a linear response when the amplifier is used in a circuit embodying the invention.

## DESCRIPTION OF EMBODIMENTS OF THE INVENTION

The invention uses a RF 'threshold PA (power amplifier)' which comprises a new form of high bandwidth (BW) RF amplifier with suitable biasing circuitry. The amplifier has a BW of at least a factor of 5, preferably at least a factor of 10 greater than the operating frequency of the signal which it is amplifying. The threshold PA is defined as a PA whose output O is either 0 (e.g. ground) or 1 (e.g. a voltage defined by the supply voltage used), dependent on the input signal I. If the input signal I is above the level of a given threshold T, the output is 1. If the input is equal to or below the given threshold level T, the output is 0.

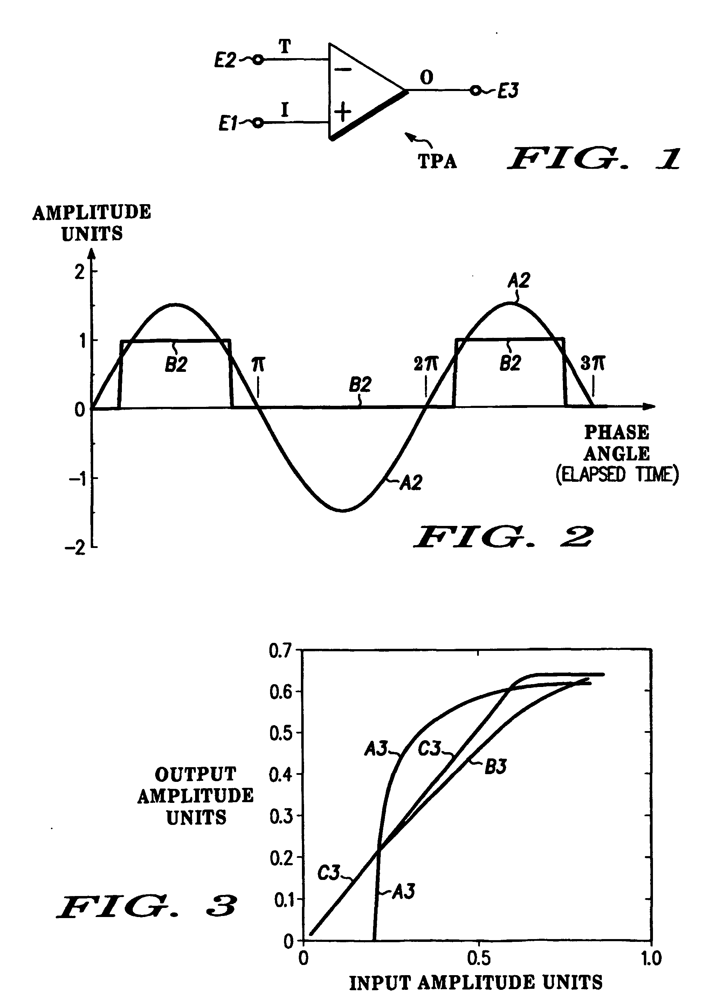

Such a threshold amplifier TPA is illustrated in Figure 1. The threshold amplifier TPA has two inputs namely an input signal I to be amplified which is applied to a first input terminal E1, a threshold signal T which is applied to a second input terminal E2 and output signal O produced at a third or output terminal E3. The output signal O for a given input signal I and threshold signal T is as defined above. In practice, the input terminals E1 and E2 may be combined at a common input electrode of an amplifying device within the threshold PA, e.g. the gate of a MOSFET.

The principle of operation of such a threshold PA will now be described and illustrated with reference to Figure 2. The input signal I for the threshold PA is a narrowband signal with both amplitude and phase information of the form:

$$I = A \cos(\omega t + \varphi) \qquad \text{Equation 1}$$

where A represents a peak amplitude, and $\omega$, t and $\varphi$ represent respectively angular frequency, time and phase.

The output O of the threshold PA will be:

$$O = 1 \text{ if } I > T$$

$$O = 0 \text{ if } I \leq T$$

For narrowband signals the operation of the threshold PA can be analysed assuming that for a given moment in time the values of A and φ are constant. This operation is illustrated in Figure 2. For simplicity, ω can be normalised to 1 and φ can be set to 0 and it can be shown that the output O of the threshold PA is:

$$O = 1 \text{ for } 0 < t < \alpha$$

$$0 \text{ for } \alpha < t < 2n - \alpha$$

$$1 \text{ for } 2n - \alpha < t < 2\pi$$

where t is the phase angle of the signal (or elapsed time) and $\alpha$ is a particular phase angle which is given by:

$$\alpha = \arccos(T/A) \text{ for } A > T \text{ and } \alpha = 0 \text{ for } T \geq A.$$

The threshold T is assumed to be positive (like the peak amplitude A of the input I).

For an input I to the threshold PA which is a sine wave having a peak amplitude A of 1.5 (arbitrary) amplitude units as represented by curve A2 in Figure 2 and a threshold T which is 0.8 amplitude units, the output O of the threshold PA is roughly a rectangular wave as indicated by waveform B2 having a height of approximately 1 amplitude unit as shown in Figure 2.

It can be shown that the width of the output signal pulses in the waveform B2 produced by the threshold PA is proportional to the amplitude of the input I, i.e. the output signal O is pulse width modulated in accordance with the input amplitude variations. In practice, the output O of the threshold PA contains harmonics. Higher harmonics may be filtered away in a known manner by passing the output O through a low pass filter (LPF) so that only the first harmonic remains. It can be shown using Fourier analysis that the amplitude and phase of the first harmonic of the output signal O are given by:

$$O_{1st} = 2/\pi \, \sin(a) \, \cos(\omega t + \varphi), \qquad \text{- Equation 2,}$$

which may be expressed as:

$$O_{1st} = 2/n \, \sin(\arccos(T/A))\cos(\omega t + \varphi) \qquad \text{- Equation 3}$$

For A > T, the threshold PA shows a finite small signal gain. This is a feature that a conventional class C amplifier does not show. This unexpected beneficial feature allows the threshold PA to be a part of a power amplification system.

By having a fixed level for the value of the threshold T, the threshold PA will be highly non-linear. However, it is possible to adjust the functional relationship between the amplitude of the input signal I and the amplitude of the output signal O. In particular, in accordance with the invention, the threshold T can be dynamically or adaptively adjusted so that the threshold PA produces an output signal O which in at least part of its range has an amplitude which is a linear function of the amplitude of the input signal I. For example, the threshold signal T may be varied in one of the ways described earlier, namely: (i) as a function of the input amplitude by sampling the input amplitude using a feed forward loop arrangement; or (ii) as a function of a signal representing the input amplitude by calculating what the input amplitude will be; or (iii) as a function of the output amplitude by sampling the output amplitude in a feedback loop arrangement, or a combination of these ways, to achieve this linearisation.

A suitable threshold signal T for application to the threshold PA may be obtained by use of an operator applying a transfer function to a suitable input to the operator. This is illustrated further as follows.

Figure 3 illustrates the effect of using different transfer functions to generate the threshold signal T. If the threshold signal T is a constant (0.2 input amplitude units) the highly non-linear curve A3 shown in Figure 3 is obtained for the relationship between input amplitude and output amplitude. However, if the transfer function is changed to:

$$T = A - (\pi^2/8)A^3 \qquad \text{Equation 4}$$

where Equation 4 is an approximate simplified solution of Equation 3 given earlier to obtain T, the response curve B3 shown in Figure 3 is obtained. Curve B3 has improved linearity compared with curve A3.

If a more precise solution for T is obtained from Equation 3 by using as a transfer function:

$$T = A \cos(\arcsin[A\pi/2]) \qquad \text{Equation 5}$$

then the response obtained is as represented by curve C3 shown in Figure 3 which beneficially is substantially linear over a large part of its range.

Responses such as those illustrated by curves B3 and C3 shown in Figure 3 may be obtained by use of the appropriate transfer function to derive a suitable variable signal as the threshold signal T. The variable signal may be generated by applying in an operator the appropriate transfer function (Equation 4 or Equation 5) to a signal representing the input I, produced either by sampling the input signal I or by calculation from the signal employed for modulation which will result in a given input signal I as described earlier.

Linearity in at least part of the response curve may also be obtained by sampling the output O of the threshold PA and applying in an operator in a feedback loop arrangement one or more transfer functions to the sampled signal to obtain an appropriate dynamically varying threshold signal T.

For very small input amplitudes, the threshold T may become only marginally smaller than the input signal and the required bandwidth of the threshold PA may become very high as the output O correspondingly becomes a series of only very narrow pulses. However, in practice, a smooth transition to a threshold PA will take place almost automatically in a class C PA implementation as there will not be infinite gain for small signals and also the amplifier will have a limited BW.

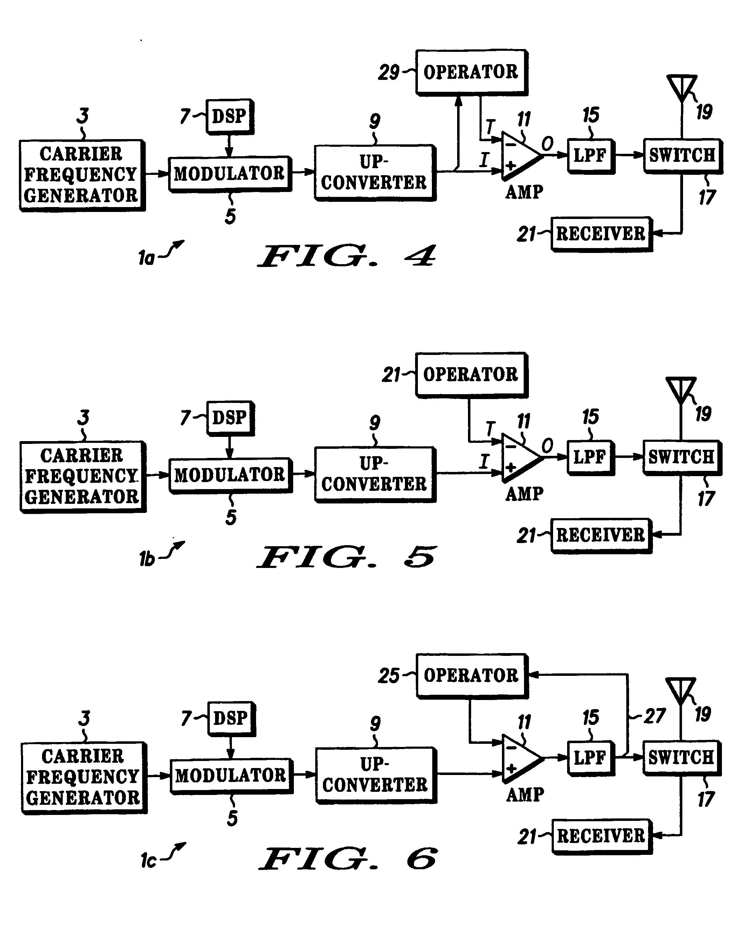

Figures 4 to 8 show examples of circuits embodying the invention using the threshold PA which has been described with reference to Figures 1 to 3. The circuits shown in Figures 4 to 8 are various forms of transceiver circuit for use in a MS or a BTS of a radio communications transceiver. Components which in Figures 4 to 8 have the same reference numerals have like functions.

In Figure 4, a transceiver la is shown. A carrier frequency generator 3 produces a baseband carrier frequency signal which is applied to a modulator 5. The baseband carrier frequency signal is modulated in the modulator 5 by applying thereto digital data from a DSP (digital signal processor) 7. The modulated output from the modulator 5 is applied to an upconverter 9 which converts the modulated baseband signal to a modulated RF signal. The modulated RF signal is applied as an input signal I to a threshold PA (power amplifier) 11 as described earlier. A sample of the input signal I is fed to an operator 13 which applies a transfer function to the sampled signal to produce a threshold signal T which is also applied as an input to the threshold PA 11. An amplified output signal O is produced by the threshold PA 11 and is filtered by a LPF (low pass filter) 15 which extracts from the output signal O harmonics other than the first harmonic. The amplified and filtered output signal from the LPF 15 is delivered via a switch 17 to an antenna 19 which transmits the signal over the air as a RF signal to a remote receiver (not shown). Incoming RF signals may be received by the antenna 19 and diverted by the switch 17 to be processed by a receiver 21 in a known manner.

The operator 13 is a device which applies a suitable transfer function to the sampled input signal I in one of the ways described earlier, e.g. using the function defined by Equation 3 or Equation 4, to produce a suitable threshold signal T. The threshold signal T which is produced will have an instantaneous amplitude which is a suitable fraction of the instantaneous amplitude of the input signal I to give an appropriate pulse width in the output signal O as explained earlier with reference to Figure 2. As stated earlier, the operator 13 may include the following components: a signal peak monitor which measures the value of the peak envelope of the input signal I being sampled and a processor. The processor may include an A to D (analogue to digital) converter which digitises the measured values, a digital signal processor which applies the transfer function as a mathematical operation, a D to A (digital to analogue) converter which converts the digitally transformed signal back into a voltage waveform suitable for use as the threshold signal T and one or more amplifiers to amplify the signal being processed.

The functions of the DSP 7 and at least part of the operator 13 shown in Figure 4, especially the part carrying out the mathematical operation, may in practice be combined in a single processing unit (e.g. a digital microprocessor produced and programmed to operate in a known manner).

Alternatively, the processor of the operator 13 can be an analogue circuit which operates on the peak signal by applying a function which approximates to Equation 5.

In Figure 5 an alternative transceiver 1b is shown. The transceiver 1b operates in a similar manner to the transceiver 1a of Figure 4 except that an operator 21 is used in place of the operator 13. The operator 21 receives an input from the DSP 7. The signal from the DSP 7 contains the digital information employed to produce modulations in the modulator 5. The signal is processed by the operator 21 so as to transform the signal into a corresponding threshold signal T which has an amplitude variation calculated to be proportional to that of the actual input signal I.

In Figure 6 a further alternative transceiver 1c is shown. In this case, the operator 21 is replaced by an operator 25. The operator 25 receives via a feedback loop 27 a sample of the output signal produced by the LPF 15. The operator 25 processes the sampled signal by applying a transfer function thereto which will linearise the response of the threshold PA 11 when the transformed signal is applied as the variable threshold signal T to the threshold PA 11. In a feedback loop arrangement such as that shown in Figure 6, the time constant of the operator 25 is adjusted to suit the feedback loop dynamics and the bandwidth of the signal being processed in the feedback loop.

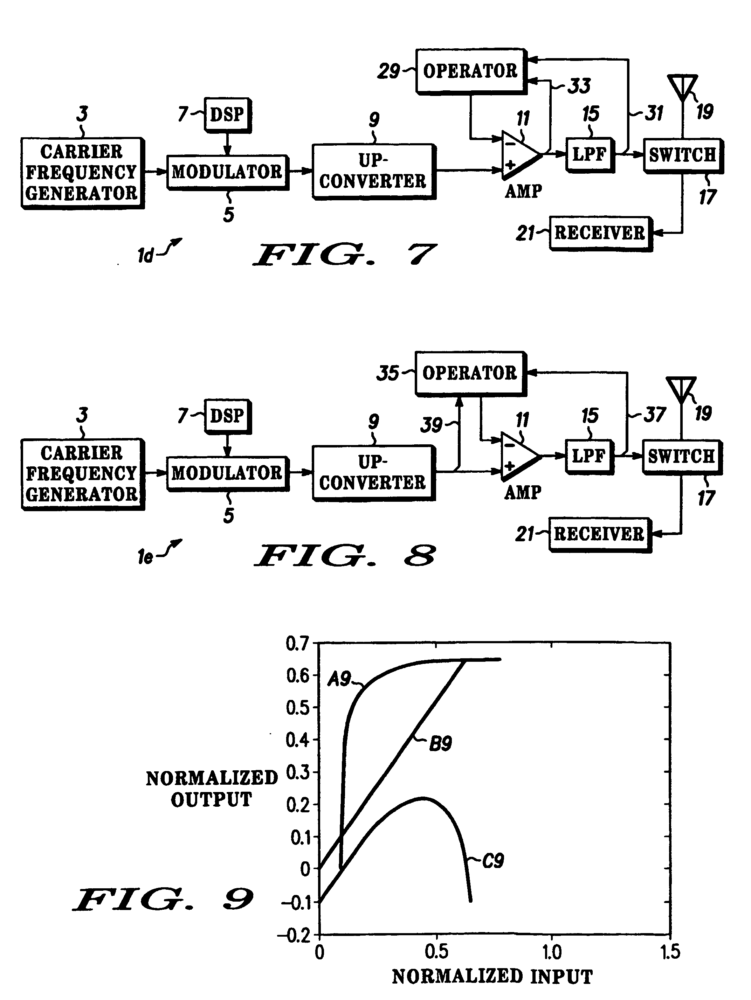

In Figure 7 a further alternative transceiver 1d is shown. In this case, the operator 25 is replaced by an operator 29. The operator 29 receives via a feedback loop 31 a sample of the output signal produced by the LPF 15 in a similar manner to the arrangement using the feedback loop 27 in Figure 4. However, in Figure 7 the operator 29 also receives via a further feedback loop 33 an input which comprises a sample of the output of the threshold PA 11 prior to filtering in the LPF 15. The operator 29 processes the sampled signals by applying thereto suitable transfer functions. The processed signals are combined to provide the variable threshold signal T which is applied to the threshold PA 11 to linearise the response of threshold PA 11.

In Figure 8 an alternative transceiver 1d is shown. In this case, the operator 25 (Figure 6) is replaced by an operator 35. The operator 35 receives via a feedback loop 37 a sample of the output signal produced by the LPF 15. The operator 35 also receives as an input signal via a feed forward connection 39 a sample of the input signal I as in the arrangement of Figure 4. The operator 35 processes the sampled signals forming its respective inputs by applying thereto suitable transfer functions. The transformed signals are combined and employed to provide the variable threshold signal T which when applied to the threshold PA 11 together with the input signal I further linearises the response of the threshold PA 11.

In a further alternative transceiver (not shown) which is a modified form of that shown in Figure 8, the operator employed to produce the threshold signal T may apply a transform function which gives PID (a combination of proportional, integral and derivative) control of the threshold signal T.

Figure 9 gives a further illustration in graphical form of the transfer function required to provide a threshold signal T in a transceiver arrangement as shown in Figure 4 to give a linear response in the operation of an RF power amplifier in class C configuration. Assume that the amplifier ('class C PA') has the conventional response shown as the curve A9 in Figure 9. There will be no output until the amplitude of the input is above 0.1. The level of 0.1 is an arbitrary amplitude level which could for example result from the gate-source voltage drop in a MOSFET with very high gain. It can be seen that curve A9 is highly non-linear. When the normalised input level of $2/\pi$ is reached the maximum output level of the class C PA is achieved.

Assume that the class C PA is used as the threshold PA 11 in an arrangement as shown in Figure 4 and is supplied with a threshold signal T such that the required response curve is linear. The required linear response curve is shown as line B9 in Figure 9. The threshold signal T required to provide this response as a function of the input follows the curve C9. For input levels below 0.1 a negative threshold is required to offset the input to the class C PA so that overall its input is greater than 0.1 so that the class C PA is still is excited. For input levels above 0.1 the threshold signal T offsets the input signal I to the class C PA less than the peak of the input signal I supplied, thereby reducing the output (curve B9) compared to the output (curve A9) obtained if the threshold signal had not been applied. A transfer function giving the curve C9 can be implemented in one of the ways described earlier.

**Claims**

1.  An RF amplifier circuit comprising an RF amplifying device (11) having a first input terminal (E1), a second input terminal (E2) and an output terminal (E3), means (9) for applying to the first input terminal an input RF signal I to be amplified, means (29) for generating and applying to the second input terminal a threshold signal T, and the amplifying device being operable to produce at the output terminal an output signal O which has a high finite value providing a Boolean '1' value when the instantaneous value of the amplitude of I is greater than T and a low finite value providing a Boolean '0' value when the instantaneous value of the amplitude of I is less than T, wherein the threshold signal is dynamically varied in a manner adapted to linearise the relationship in at least part of its range between the amplitude of the output signal O and the amplitude of the input signal I.

2.  An RF amplifier circuit according to claim 1 wherein the means for generating and applying a threshold signal T is operable to apply a non-constant transfer function to a signal representative of the input signal.

3.  An RF amplifying circuit according to claim 1 or claim 2 and which has a bandwidth of at least five times, preferably at least ten times, greater than the mean operating frequency of the signal which it is operable to amplify.

4.  An RF amplifier circuit according to claim 1, claim 2 or claim 3 and wherein the output terminal is connected to a low pass filter operable to filter out harmonics higher than the first harmonic in the output signal O.

5. An RF amplifier according to any one preceding claim and wherein the threshold signal T is controlled to be a variable signal having a constant sign.

6. An RF amplifying circuit according to any one of the preceding claims and wherein the threshold signal T is in operation dynamically varied as a function of the input signal I by sampling the input signal I prior to application to the amplifying device, the means for generating the threshold signal T including a feed forward loop which includes means for deriving at least part of the threshold signal T from the sampled input signal I.

7. An RF amplifying circuit according to any one of the preceding claims and wherein the threshold signal T is in operation dynamically varied as a function of the output signal O by sampling the output signal O produced by the amplifying device, optionally after further processing, the means for applying the threshold signal T including a feedback loop which includes means for providing as the threshold signal T a signal derived at least in part from the sampled output signal O.

8. An amplifier circuit according to any one of the preceding claims wherein the means for providing the threshold signal T is operable to produce from the sampled signal or signals a signal which is related to the envelope of the sampled signal.

9. An RF amplifying circuit according to any one of the preceding claims and wherein the means for generating the threshold signal T includes a digital signal processor operable to calculate from modulation information applied to produce the input signal I a form of the input signal I.

10. An RF amplifying circuit according to claim 8 and wherein the circuit includes a digital signal processor operable to produce modulation information for use in modulation to form the input signal I and also to carry out calculations using the modulation information to derive at least part of the threshold signal T.

11. An RF amplifying circuit according to any one of the preceding claims and wherein the means for generating the threshold signal T includes (i) a signal peak monitor which is operable to measure the value of the peak of a signal being sampled and produces a peak envelope signal, (ii) an A to D (analogue to digital) converter which is operable to digitise the peak envelope signal; a digital signal processor which is operable to apply a transform function to the digitised peak envelope signal; and a D to A (digital to analogue) converter which is operable to convert the digitally transformed signal produced by the digital signal processor back into a waveform suitable for use as the threshold signal T or a component thereof.

12. An RF amplifying circuit according to claim 11 and wherein the means for generating the threshold signal T also includes an amplifier or a plurality of amplifiers to amplify the signal being processed to produce the variable threshold signal T.

13. An RF amplifying circuit according to any one of the preceding claims and wherein the means for generating the threshold signal T is operable to apply proportional, derivative and integral control to produce the threshold signal T.

14. An RF amplifying circuit according to any one of the preceding claims and wherein the means for generating the threshold signal T is operable to apply a transfer function to a monitored signal by use of a look up table held in a memory which stores corresponding values of the signal before and after application of the transfer function.

15. An RF amplifying circuit according to any one of the preceding claims and which is such that a plot of amplitude of the output signal O against amplitude of the input signal I is linear over at least 90% of its range.

16. An RF amplifying circuit according to any one of the preceding claims and wherein the amplifying device employed in the circuit is arranged in a class C configuration modified so that in operation the input signal I and the threshold signal T are applied together via separate input terminals to be combined at a single electrode of the amplifying device.

17. An RF amplifying circuit according to any one of the preceding claims and wherein the amplifying device comprises a solid state amplifying device.

18. An RF amplifying circuit according to any one of the preceding claims and wherein in operation the threshold signal T is applied as a variable bias to the amplifying device or is combined with the input signal I at an input to the amplifying device.

19. An RF amplifying circuit according to any one of the preceding claims and wherein the amplifier circuit includes two or more amplifying devices mutually connected in series or in parallel.

20. An RF communications transmitter which includes an amplifier circuit according to any one of the preceding claims.

21. An RF communications transmitter according to claim 20 and which is incorporated in a mobile station or a base transceiver station for use in a mobile communications system.

22. An RF communications transmitter according to claim 21 and which is incorporated in a mobile station or a base transceiver station for use in a mobile communications system operable to employ phase modulated RF signals.

23. An RF communications transmitter according to claim 22 and which is incorporated in a mobile station or a base transceiver station for use in a mobile communications system operable according to TETRA standards.

24. An RF communications transmitter according to claim 23 and wherein the amplifier circuit is operable to provide a linear response in an output signal strength range of at least 70dB.

**Patentansprüche**

1. Hochfrequenzverstärkerschaltkreis, umfassend eine Hochfrequenzverstärkereinrichtung (11) mit einem ersten Eingangsanschluss (E1), einem zweiten Eingangsanschluss (E2) und einem Ausgangsanschluss (E3), Mittel (9) zum Anlegen eines zu verstärkenden Hochfrequenzeingangssignals I an den ersten Eingangsanschluss sowie Mittel (29) zum Erzeugen und Anlegen eines Schwellenwertsignals T an den zweiten Eingangsanschluss, wobei die Verstärkereinrichtung betreibbar ist, an dem Ausgangsanschluss ein Ausgangssignal O zu erzeugen, welches einen hohen endlichen Wert aufweist, der einen Bool'schen Wert "1" bereitstellt, wenn der momentane Wert der Amplitude des Signals I größer ist als T, und der einen niedrigen endlichen Wert aufweist, der einen Bool'schen Wert von "0" bereitstellt, wenn der momentane Wert der Amplitude des Signals I kleiner ist als T, wobei das Schwellenwertsignal in einer Weise dynamisch variiert wird, die geeignet ist, das Verhältnis zwischen der Amplitude des Ausgangssignals O und der Amplitude des Eingangssignals I zumindest in einem Teil seines Wertebereiches zu linearisieren.

2. Hochfrequenzverstärkerschaltkreis nach Anspruch 1, wobei das Mittel zum Erzeugen und Anlegen eines Schwellenwertsignals T betreibbar ist, eine nicht-konstante Übertragungsfunktion auf ein das Eingangssignal repräsentierendes Signal anzuwenden.

3. Hochfrequenzverstärkerschaltkreis gemäß Anspruch 1 oder Anspruch 2 und welcher eine wenigstens fünffach, vorzugsweise wenigstens zehnfach größere Bandbreite als die Hauptbetriebsfrequenz des Signals hat, welches er verstärken kann.

4. Hochfrequenzverstärkerschaltkreis nach Anspruch 1, Anspruch 2 oder Anspruch 3 und wobei der Ausgangsanschluss an ein Tiefpassfilter angeschlossen ist, welches betreibbar ist, die Harmonischen oberhalb der ersten Harmonischen in dem Ausgangssignal O herauszufiltern.

5. Hochfrequenzverstärker nach einem der vorangegangen Ansprüche und wobei das Schwellenwertsignal T so gesteuert wird, dass es ein variables Signal mit konstantem Vorzeichen ist.

6. Hochfrequenzverstärkerschaltkreis nach einem der vorangegangenen Ansprüche und wobei das Schwellenwertsignal T während des Betriebs dynamisch als Funktion des Eingangssignals I variiert wird, indem das Eingangssignal I abgetastet wird, bevor es an die Verstärkereinrichtung angelegt wird, und wobei das Mittel zum Erzeugen des Schwellenwertsignals T einen Vorwärtsregelkreis mit einem Mittel zum Herleiten von wenigstens einem Teil des Schwellenwertsignals T aus dem abgetasteten Eingangssignal I umfasst.

7. Hochfrequenzverstärkerschaltkreis nach einem der vorangegangenen Ansprüche und wobei das Schwellenwertsignal T während des Betriebs dynamisch als Funktion des Ausgangssignals O variiert wird, indem das von der Verstärkereinrichtung erzeugte Ausgangssignal O, wahlweise nach einer weiteren Bearbeitung, abgetastet wird, und wobei das Mittel zum Anlegen des Schwellenwertsignals T einen (Rückwärts-) Regelkreis mit einem Mittel zum Bereitstellen eines wenigstens teilweise aus dem abgetasteten Ausgangssignal O hergeleiteten Signals als das Schwellenwertsignal T aufweist.

8. Verstärkerschaltkreis nach einem der vorangegangenen Ansprüche, wobei das Mittel zum Bereitstellen des Schwellenwertsignals T so betreibbar ist, dass es aus dem abgetasteten Signal oder aus den abgetasteten Signalen ein Signal erzeugt, welches mit der Hüllkurve des abgetasteten Signals in Beziehung steht.

9. Hochfrequenzverstärkerschaltkreis nach einem der vorangegangenen Ansprüche und wobei das Mittel zum Erzeugen des Schwellenwertsignals T einen digitalen Signalprozessor aufweist, welcher betreibbar ist, aus der Modulationsinformation, welche zur Erzeugung des Eingangssignals verwendet wurde, eine Form des Eingangssignals I zu berechnen.

10. Hochfrequenzverstärkerschaltkreis nach Anspruch 8 und wobei der Schaltkreis einen digitalen Signalprozessor umfasst, welcher betreibbar ist, Modulationsinformationen zu erzeugen zur Verwendung bei Modulationen zum Bilden des Eingangssignals I und welcher ebenfalls betreibbar ist zum Ausführen von Berechnungen unter Verwendung der Modulationsinformation zum Herleiten von wenigstens einem Teil des Schwellenwertsignals T.

11. Hochfrequenzverstärkerschaltkreis nach einem der vorangegangenen Ansprüche und wobei das Mittel zum Erzeugen des Schwellenwertsignals T umfasst (i) eine Signalspitzenüberwachungseinrichtung, welche zum Messen des Wertes der Spitze eines abgetasteten Signals und zum Erzeugen eines Spitzen-Hüllkurvensignals betreibbar ist, (ii) einen Analog-/Digital-Wandler, welcher betreibbar ist, das Spitzen-Hüllkurvensignal zu digitalisieren; einen digitalen Signalprozessor, welcher betreibbar ist, eine Übertragungsfunktion auf das digitalisierte Spitzen-Hüllkurvensignal anzuwenden; und einen Digital-/AnalogWandler, welcher betreibbar ist, das digital transformierte, von dem digitalen Signalprozessor erzeugte Signal in eine Signalform zurückumzuwandeln, welche für eine Verwendung als das Schwellenwertsignal T oder eine Komponente davon geeignet ist.

12. Hochfrequenzverstärkerschaltkreis nach Anspruch 11 und wobei das Mittel zum Erzeugen des Schwellenwertsignal T weiterhin einen Verstärker oder eine Vielzahl von Verstärkern zum Verstärken des Signals umfasst, welches verarbeitet wird, um das variable Schwellenwertsignal T zu erzeugen.

13. Hochfrequenzverstärkerschaltkreis nach einem der vorangegangenen Ansprüche und wobei das Mittel zum Erzeugen des Schwellenwertsignals T betreibbar ist, eine proportionale, eine differentiale und eine integrale Regelung anzuwenden, um das Schwellenwertsignal T zu erzeugen.

14. Hochfrequenzverstärkerschaltkreis nach einem der vorangegangenen Ansprüche und wobei das Mittel zum Erzeugen des Schwellenwertsignals T betreibbar ist, eine Übertragungsfunktion auf ein überwachtes Signal durch Verwendung einer in einem Speicher enthaltenen Nachschlagtabelle anzuwenden, wobei der Speicher korrespondierende Werte des Signals vor und nach Anwendung der Übertragungsfunktion speichert.

15. Hochfrequenzverstärkerschaltkreis nach einem der vorangegangenen Ansprüche und welcher so ausgebildet ist, dass eine grafische Darstellung der Amplitude des Ausgangssignals O über beziehungsweise in Abhängigkeit der Amplitude des Eingangssignals I über wenigstens 90% ihres Wertebereiches linear verläuft.

16. Hochfrequenzverstärkerschaltkreis nach einem der vorangegangenen Ansprüche und wobei die in dem Schaltkreis benutzte Verstärkereinrichtung in einer C-Klasse-Konfiguration angeordnet ist, welche so modifiziert ist, dass das Eingangssignal I und das Schwellenwertsignal T während des Betriebs zusammen über separate Eingangsanschlüsse angelegt werden, um an einer einzelnen Elektrode der Verstärkereinrichtung miteinander kombiniert zu werden.

17. Hochfrequenzverstärkerschaltkreis nach einem der vorangegangenen Ansprüche und wobei die Verstärkereinrichtung eine Halbleiterverstärkereinrichtung aufweist.

18. Hochfrequenzverstärkerschaltkreis nach einem der vorangegangenen Ansprüche und wobei während des Betriebs das Schwellenwertsignal T als variable Vorspannung an die Verstärkereinrichtung angelegt oder an einem Eingang der Verstärkereinrichtung mit dem Eingangssignal I kombiniert wird.

19. Hochfrequenzverstärkerschaltkreis nach einem der vorangegangenen Ansprüche und wobei der Verstärkerschaltkreis zwei oder mehr Verstärkereinrichtungen aufweist, welche zueinander wechselseitig in Reihe oder parallel geschaltet sind.

20. Hochfrequenzkommunikationssender, welcher einen Verstärkerschaltkreis gemäß einem der vorangegangenen Ansprüche umfasst.

21. Hochfrequenzkommunikationssender gemäß Anspruch 20 und welcher in ein Mobiltelefon oder eine Basis-Transceiver-Station eingebaut ist zur Verwendung in einem Mobilkommunikationssystem.

22. Hochfrequenzkommunikationssender gemäß Anspruch 21 und welcher in ein Mobiltelefon oder eine Basis-Transceiver-Station eingebaut ist zur Verwendung in einem Mobilkommunikationssystem, welches betreibbar ist, phasenmodulierte Hochfrequenzsignale zu benutzen.

23. Hochfrequenzkommunikationssender gemäß Anspruch 22 und welcher in ein Mobiltelefon oder eine Basis-Transceiver-Station eingebaut ist zur Verwendung in einem Mobilkommunikationssystem, welches gemäß den TETRA-Standards betreibbar ist.

24. Hochfrequenzkommunikationssender gemäß Anspruch 23 und wobei der Verstärkerschaltkreis betreibbar ist, ein lineares (Ansprech-)Verhalten in einem Bereich der Stärke des Ausgangssignals von wenigstens 70dB bereitzustellen.

**Revendications**

1. Circuit amplificateur RF comprenant un dispositif d'amplification RF (11) ayant une première borne d'entrée (E1), une seconde borne d'entrée (E2) et une borne de sortie (E3), un moyen (9) pour appliquer à la première borne d'entrée un signal RF d'entrée I devant être amplifié, un moyen (29) pour générer et appliquer à la seconde borne d'entrée un signal de seuil T, et le dispositif d'amplification étant opérationnel pour produire au niveau de la borne de sortie un signal de sortie O qui a une valeur finie élevée fournissant une valeur « 1 » booléenne lorsque la valeur instantanée de l'amplitude de I est supérieure à T et une valeur finie basse fournissant une valeur « 0 » booléenne lorsque la valeur instantanée de l'amplitude de I est inférieure à T, dans lequel le signal de seuil est varié dynamiquement d'une manière adaptée pour linéariser la relation dans au moins une partie de sa gamme entre l'amplitude du signal de sortie O et l'amplitude du signal d'entrée I.

2. Circuit amplificateur RF selon la revendication 1, dans lequel le moyen pour générer et appliquer un signal de seuil T est opérationnel pour appliquer une fonction de transfert non constante à un signal représentatif du signal d'entrée.

3. Circuit d'amplification RF selon la revendication 1 ou la revendication 2 et qui a une largeur de bande d'au moins cinq fois, de préférence d'au moins dix fois, supérieure à la fréquence de fonctionnement moyenne du signal qu'il est opérationnel pour amplifier.

4. Circuit amplificateur RF selon la revendication 1, la revendication 2 ou la revendication 3 et dans lequel la borne de sortie est connectée à un filtre passe-bas opérationnel pour éliminer par filtrage les harmoniques supérieurs au premier harmonique dans le signal de sortie O.

5. Circuit amplificateur RF selon l'une quelconque des revendications précédentes et dans lequel le signal de seuil T est commandé pour être un signal variable ayant un signe constant.

6. Circuit d'amplification RF selon l'une quelconque des revendications précédentes et dans lequel le signal de seuil T est en fonctionnement varié dynamiquement en fonction du signal d'entrée I en échantillonnant le signal d'entrée I avant l'application au dispositif d'amplification, le moyen pour générer le signal de seuil T incluant une boucle d'anticipation qui inclut un moyen pour dériver au moins une partie du signal de seuil T du signal d'entrée échantillonné I.

7. Circuit d'amplification RF selon l'une quelconque des revendications précédentes et dans lequel le signal de seuil T est en fonctionnement varié dynamiquement en fonction du signal de sortie O en échantillonnant le signal de sortie O produit par le dispositif d'amplification, facultativement après un autre traitement, le moyen pour appliquer le signal de seuil T incluant une boucle de rétroaction qui inclut un moyen pour fournir en tant que signal de seuil T un signal dérivé au moins en partie du signal de sortie échantillonné O.

8. Circuit amplificateur selon l'une quelconque des revendications précédentes, dans lequel le moyen pour fournir le signal de seuil T est opérationnel pour produire à partir du signal ou des signaux échantillonnés un signal qui est lié à l'enveloppe du signal échantillonné.

9. Circuit d'amplification RF selon l'une quelconque des revendications précédentes et dans lequel le moyen pour générer le signal de seuil T inclut un processeur de signal numérique opérationnel pour calculer à partir de l'information de modulation appliquée pour produire le signal d'entrée I une forme du signal d'entrée I.

10. Circuit d'amplification RF selon la revendication 8 et dans lequel le circuit inclut un processeur de signal numérique opérationnel pour produire une information de modulation pour l'utilisation dans la modulation pour former le signal d'entrée I et également pour effectuer les calculs en utilisant l'information de modulation pour dériver au moins une partie du signal de seuil T.

11. Circuit d'amplification RF selon l'une quelconque des revendications précédentes et dans lequel le moyen pour générer le signal de seuil T inclut (i) un moniteur de signal de crête qui est opérationnel pour mesurer la valeur de la crête d'un signal qui est échantillonné et produit un signal d'enveloppe de crête, (ii) un convertisseur A/N (analogique-numérique) qui est opérationnel pour numériser le signal d'enveloppe de crête ; un processeur de signal numérique qui est opérationnel pour appliquer une fonction de transformation au signal d'enveloppe de crête numérisé ; et un convertisseur N/A (numérique-analogique) qui est opérationnel pour reconvertir le signal transformé numériquement produit par le processeur de signal numérique en une forme d'onde appropriée pour l'utilisation en tant que signal de seuil T ou une composante de celui-ci.

12. Circuit d'amplification RF selon la revendication 11 et dans lequel le moyen pour générer le signal de seuil T inclut également un amplificateur ou une pluralité d'amplificateurs pour amplifier le signal qui est traité pour produire le signal de seuil variable T.

13. Circuit d'amplification RF selon l'une quelconque des revendications précédentes et dans lequel le moyen pour générer le signal de seuil T est opérationnel pour appliquer une régulation proportionnelle, par action dérivée et par action intégrale pour produire le signal de seuil T.

14. Circuit d'amplification RF selon l'une quelconque des revendications précédentes et dans lequel le moyen pour générer le signal de seuil T est opérationnel pour appliquer une fonction de transfert à un signal surveillé en utilisant une table à consulter contenue dans une mémoire qui stocke les valeurs correspondantes du signal avant et après l'application de la fonction de transfert.

15. Circuit d'amplification RF selon l'une quelconque des revendications précédentes et qui est tel qu'un tracé de l'amplitude du signal de sortie O par rapport à l'amplitude du signal d'entrée I est linéaire sur au moins 90 % de son étendue.

16. Circuit d'amplification RF selon l'une quelconque des revendications précédentes et dans lequel le dispositif d'amplification employé dans le circuit est disposé dans une configuration de classe C modifiée de sorte qu'en fonctionnement le signal d'entrée I et le signal de seuil T soient appliqués ensemble via des bornes d'entrée séparées pour être combinés au niveau d'une seule électrode du dispositif d'amplification.

17. Circuit d'amplification RF selon l'une quelconque des revendications précédentes et dans lequel le dispositif d'amplification comprend un dispositif d'amplification à semiconducteurs.

18. Circuit d'amplification RF selon l'une quelconque des revendications précédentes et dans lequel en fonctionnement le signal de seuil T est appliqué comme une polarisation variable au dispositif d'amplification et est combiné avec le signal d'entrée I au niveau d'une entrée au dispositif d'amplification.

19. Circuit d'amplification RF selon l'une quelconque des revendications précédentes et dans lequel le circuit amplificateur inclut deux dispositifs d'amplification ou plus mutuellement connectés en série ou en parallèle.

20. Emetteur de communications RF qui inclut un circuit amplificateur selon l'une quelconque des revendications précédentes.

21. Emetteur de communications RF selon la revendication 20 et qui est incorporé dans une station mobile ou une station d'émission-réception de base pour une utilisation dans un système de communications mobiles.

22. Emetteur de communications RF selon la revendication 21 et qui est incorporé dans une station mobile ou une station d'émission-réception de base pour une utilisation dans un système de communications mobiles exploitable pour employer des signaux RF à modulation de phase.

23. Emetteur de communications RF selon la revendication 22 et qui est incorporé dans une station mobile ou une station d'émission-réception de base pour une utilisation dans un système de communications mobiles exploitable selon les normes TETRA.

24. Emetteur de communications RF selon la revendication 23 et dans lequel le circuit amplificateur est opérationnel pour fournir une réponse linéaire dans une gamme de force du signal de sortie d'au moins 70 dB.

FIG. 1

FIG. 2

FIG. 3

FIG. 4

FIG. 5

FIG. 6

FIG. 7

FIG. 8

FIG. 9